# EUROPEAN PATENT APPLICATION

(11) **EP 4 625 602 A1**
(43) Date of publication of application: **01.10.2025**
(21) Application number: 24860358.1
(22) Date of filing: 26.08.2024
(51) Int. Cl.: H01M 10/42, H01M 10/052, H01M 4/134, H01M 4/36, H01M 50/531, G01R 27/02, G01R 31/389, G01R 31/392, G01R 29/02, G01R 23/02

(54) **RESISTANCE MEASUREMENT METHOD OF ANODE OF SECONDARY BATTERY, AND SECONDARY BATTERY CAPABLE OF MEASURING RESISTANCE OF ANODE**

(30) Priority: 25.08.2023 KR 20230112035
(71) Applicant: LG Energy Solution, Ltd., Seoul 07335 (KR)
(72) Inventor: AHN, Ji-Hoon, Daejeon 34122 (KR); KIM, Yun-Jung, Daejeon 34122 (KR); HONG, Kyung-Sik, Daejeon 34122 (KR)
(74) Representative: Goddar, Heinz J.
(86) International application number: PCT/KR2024/012731
(87) International publication number: WO 2025/048438

(57) **Abstract**

A negative electrode included in a secondary battery according to the present disclosure is a free-standing type electrode including a negative electrode active material but not having a current collector, and includes a first negative electrode tab and a second negative electrode tab extended in opposite directions.

It may be possible to measure the resistance of only the negative electrode without disassembly of the secondary battery and accurately the resistance of the negative electrode. **In** addition, it may be possible to determine the degree of degradation of the negative electrode by measuring the resistance of the negative electrode.

## Description

### TECHNICAL FIELD

The present disclosure relates to a method for measuring the resistance of a negative for a secondary battery and a secondary battery in which the resistance of the negative electrode can be measured.

This application is based on and claims priority from Korean Patent Application No. 10-2023-0112035, filed on August 25, 2023, with the Korean Intellectual Property Office, the disclosure of which is incorporated herein in its entirety by reference.

### BACKGROUND

Secondary batteries that can be repeatedly charged and discharged are gaining attention as an alternative to fossil energy. Secondary batteries have been mainly used in traditional handheld devices such as mobile phones, video cameras, and electric tools. Recently, the range of application is gradually extended to electric vehicles (EV, HEV, PHEV), large capacity energy storage systems (ESS), uninterruptible power supply systems (UPS) and so on.

A secondary battery includes an electrode assembly including a positive electrode and a negative electrode, and a separator interposed between them, and an electrolyte that electrochemically reacts with an active material coated on the positive electrode and the negative electrode, and a lithium ion secondary battery is a representative example. In the lithium ion secondary battery, electrochemical reaction occurs at the positive electrode and the negative electrode by the action of a lithium ion as a working ion during charging and discharging. In the existing lithium ion secondary batteries, lamination is applied to the assembly process to form adhesion between the electrode and the separator in the electrode assembly. The lamination is a process of joining the separator and the electrode by heat. The lamination is performed by adhering the separator and the electrode stacked at the upper and lower positions by heat, thereby increasing the adhesion strength of the separator and the electrode. The rough surface of the existing electrode including an active material, a conductive material and a binder makes it easy to form a bond between the electrode and the separator through lamination with the separator.

Recently, in efforts to improve the energy density of lithium ion secondary batteries, attention is directed towards the need for development of next-generation secondary batteries directly using lithium metal foils as the negative electrode. Lithium metal highly tends to ionize and has low density, and due to very low standard electrode potential, the specific capacity is very high. There are problems such as internal short circuits caused by lithium dendrite growth and the risk of explosion in the event of exposure to moisture, but when the problems are solved, the highest energy density can be obtained. In pursuit of the advantage, lithium metal is worthy of further research.

Lithium ion secondary batteries degrade over time. In particular, in the case of lithium metal batteries directly using a lithium metal foil as the negative electrode, the lithium metal easily forms dendrites over a wide area and reacts with salts and additives in the electrolyte solution to form a solid electrolyte interphase (SEI), so the salts and additives in the electrolyte solution are continuously consumed, and as a consequence the battery degrades faster.

Accordingly, many studies are being conducted to estimate the life or the degree of degradation of lithium metal batteries. It is known that lithium metal batteries have an increase in resistance in relation to changes in the chemical composition and physical structure of lithium metal. Using the relevance, it is thought that the degree of degradation of the lithium metal battery can be estimated by the resistance observation of the negative electrode of the lithium metal battery while in operation. However, in the existing structure of the lithium metal battery, there is no technology to independently measure the resistance of only the lithium metal negative electrode while in operation. There is a need for technology development.

### SUMMARY

### Technical Problem

The present disclosure is directed to providing a secondary battery in which the degree of degradation can be determined by measuring the resistance of a negative electrode during operation of the secondary battery and a measurement method thereof.

### Technical Solution

According to an aspect of the present disclosure, there is provided a secondary battery of the following embodiments.

The secondary battery according to a first embodiment includes:
a positive electrode; a negative electrode; and a separator between the positive electrode and the negative electrode,
wherein the negative electrode is a free-standing type electrode including a negative electrode active material but not having a current collector,
wherein the negative electrode active material includes at least one lithium-based material of a lithium metal and a lithium alloy, and
wherein the negative electrode includes a first negative electrode tab and a second negative electrode tab extended in opposite directions.

According to a second embodiment, in the first embodiment,
the positive electrode may have a positive electrode active material layer on at least one surface of a positive electrode current collector, and the positive electrode active material layer may include a sulfur-carbon composite and a binder polymer.

According to a third embodiment, in the first or second embodiment,
the positive electrode may include a positive electrode tab.

According to a fourth embodiment, in any one of the first to third embodiments,
the negative electrode may consist of the at least one lithium-based material of the lithium metal and the lithium alloy.

According to a fifth embodiment, in any one of the first to fourth embodiments,
the first negative electrode tab and the second negative electrode tab may be each extended outward from each of ends of the negative electrode on two sides in a width direction or a length direction.

According to a sixth embodiment, in any one of the first to fifth embodiments,
the first negative electrode tab and the second negative electrode tab may be located in line-symmetrical regions with respect to the negative electrode.

According to a seventh embodiment, in any one of the first to sixth embodiments,
the first negative electrode tab and the second negative electrode tab may be located in point-symmetrical regions with respect to the negative electrode.

According to an eighth embodiment, in any one of the first to seventh embodiments,
the first negative electrode tab and the second negative electrode tab may be configured to be connected to a resistance measurement device for measuring the resistance of the negative electrode.

According to a ninth embodiment, in any one of the first to eighth embodiments,
the secondary battery may be configured such that a degree of electrical degradation of the negative electrode and the secondary battery is observed by connecting a resistance measurement device to the first negative electrode tab and the second negative electrode tab.

According to a tenth embodiment, in any one of the first to ninth embodiments,
the positive electrode may have a positive electrode active material layer on at least one surface of a positive electrode current collector, and a loading amount of the negative electrode may be 1 to 2.5 times as large as a loading amount of a positive electrode active material.

According to an eleventh embodiment,
there is provided a method for measuring the resistance of the negative electrode of the secondary battery according to any one of the first to tenth embodiments, including the step of:
connecting the resistance measurement device to the first negative electrode tab and the second negative electrode tab to measure the resistance of the negative electrode.

According to a twelfth embodiment, in the eleventh embodiment,
the resistance measurement may be performed using electrochemical impedance spectroscopy.

According to a thirteenth embodiment, in the eleventh or twelfth embodiment,
the resistance measurement may be performed in an amplitude of voltage between 0.01 mV and 0.5 mV.

According to a fourteenth embodiment, in any one of the eleventh to thirteenth embodiments,
the resistance measurement may be performed at a frequency between 100 Hz and 1000 Hz.

According to a fifteenth embodiment, in any one of the eleventh to fourteenth embodiments,
the resistance measurement may be performed every time a state of charge (SOC) of the secondary battery changes by 5% ~ 20%.

### Advantageous Effects

To measure the resistance of the negative electrode in the secondary battery, disassembly has been done to separately obtain the negative electrode from the secondary battery. However, because the secondary battery according to an embodiment of the present disclosure includes the first negative electrode tab and the second negative electrode tab extending in opposite directions, it may be possible to measure the resistance of only the negative electrode without disassembly of the secondary battery to separate the negative electrode.

Additionally, the secondary battery according to an embodiment of the present disclosure may make it possible to determine the degree of electrical degradation of the negative electrode by measuring the electrical resistance between the first negative electrode tab and the second negative electrode tab in both directions during operation and to estimate the degree of degradation of the secondary battery from it. The method for measuring the resistance of the negative electrode for the secondary battery according to the present disclosure may separately measure the resistance of only the negative electrode without disassembly of the secondary battery.

### BRIEF DESCRIPTION OF THE DRAWINGS

The accompanying drawings illustrate the exemplary embodiments of the present disclosure and together with the foregoing disclosure, serve to provide a better understanding of the technical aspect of the present disclosure, and thus the present disclosure is not construed as being limited to the drawings. In the drawings, for clarity of description, the shape, size, scale or proportion of the elements may be exaggerated for emphasis.
FIG. 1 is a diagram showing a negative electrode of a secondary battery according to the related art.
FIG. 2 is a diagram showing a negative electrode of a secondary battery according to an embodiment of the present disclosure.
FIG. 3 is a diagram showing a negative electrode of a secondary battery according to an embodiment of the present disclosure.
FIG. 4 is a diagram showing a negative electrode of a secondary battery according to an embodiment of the present disclosure.
FIG. 5 is a diagram showing a negative electrode and a positive electrode of a secondary battery according to an embodiment of the present disclosure.
FIG. 6 is a graph showing a change in resistance during a charge/discharge cycle of a secondary battery according to Example 1 of the present disclosure.
FIG. 7 is a graph showing the capacity retention rate of a secondary battery according to Example 1 of the present disclosure.
FIG. 8 is a graph showing a change in resistance of a secondary battery according to Example 1 of the present disclosure.

### DETAILED DESCRIPTION

Hereinafter, the present disclosure will be described in detail with reference to the accompanying drawings. It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Accordingly, the disclosed embodiments and the illustration in the drawings are provided to describe the present disclosure by way of example but not intended to be limiting, so it should be understood that other equivalents and modifications could have been made thereto at the time the application was filed.

It should be further understood that "comprise", "include" or "have" when used in the specification, specifies the presence of stated elements and does not preclude the presence or addition of one or more other elements unless expressly stated otherwise.

In the specification, 'A and/or B' as used herein refers to either A or B or both.

Unless stated otherwise, the unit of temperature is Celsius (°C).

A first aspect of the present disclosure relates to a secondary battery.

The secondary battery according to an aspect of the present disclosure includes a positive electrode; a negative electrode; and a separator between the positive electrode and the negative electrode,
wherein the negative electrode is a free-standing type electrode including a negative electrode active material but not having a current collector,
wherein the negative electrode active material includes at least one lithium-based material of lithium metal and lithium alloy, and
wherein the negative electrode include a first negative electrode tab and a second negative electrode tab extended in opposite directions.

In an embodiment of the present disclosure, the positive electrode may have a positive electrode active material layer on at least one surface of a positive electrode current collector. The positive electrode active material layer may include a positive electrode active material and a binder polymer, and optionally may further include a conductive material.

In an embodiment of the present disclosure, the positive electrode active material may include a sulfur-carbon composite. The sulfur-carbon composite may include a sulfur-based material loaded on a porous carbon material.

The sulfur-based material may include at least one of sulfur (S₈) or a sulfur-based compound. Here, the sulfur-based compound may refer collectively to all materials containing sulfur (S). The sulfur-based compound may include, for example, all sulfur-containing compounds formed through reduction reaction of inorganic sulfur (S₈) or oxidation reaction of lithium sulfide (Li₂S), and more specifically, lithium sulfide (Li₂S), lithium polysulfide (Li₂Sₓ, x is an integer of 2 ≤ x ≤ 8), a disulfide compound, a carbon-sulfur polymer ((C₂S_{y})ₙ, y = 2.5 to 50, n ≥ 2), lithium sulfide (Li₂S) or two or more of them.

The porous carbon material may include a crystalline or amorphous carbon material, and may include a conductive carbon. The porous carbon material provides skeleton for uniform distribution and stable immobilization of the sulfur-based material and complements the low electrical conductivity of the sulfur-based material to promote electrochemical reaction.

The porous carbon material may be produced by carbonization of various carbon precursors, and may include irregularities and/or pores inside, and the average pore diameter may range from 1 nm to 200 nm, and the porosity may range from 10 vol% to 90 vol% of the total volume of the carbon material. When the average pore diameter of the carbon material lies in the aforementioned range, the mechanical strength of the carbon material can be maintained.

The porous carbon material may have any shape commonly used in lithium sulfur batteries without limitation, and may be, for example, spherical, rod-shaped, needle-shaped, plate-shaped, tubular, or bulk-shaped. In addition, the carbon material may have a high specific surface area. For example, the carbon material may include at least one selected from the group consisting of graphite, graphene, Super P, carbon black, Denka black, acetylene black, Ketjen black, channel black, furnace black, lamp black, thermal black, carbon fiber, carbon nanofiber, carbon nanotube (SWCNT, MWCNT), carbon nanowire, carbon nanoring, carbon fabric, and fullerene (C₆₀).

The sulfur-carbon composite including the sulfur-based material loaded on the porous carbon material may include sulfur-based material in an amount of from 60 wt% to 90 wt% based on the total 100 wt%. When the amount of the sulfur-based material is included in the aforementioned range, the sulfur-based material and the porous carbon material may be included in the optimum amount and binder polymer for holding the sulfur-based material and the porous carbon material together may be used in the optimum amount. Accordingly, because the binder polymer that may cause an increase in resistance may be used in the optimum amount, it may be possible to improve battery performance.

In the sulfur-carbon composite, the sulfur-based material may fill at least part of the internal space (e.g., pores) of the porous carbon material, or together with this or independently of this, the sulfur-based material may be located outside in a manner of coating at least part of the porous carbon material surface. In a specific embodiment, the sulfur-based material may be located less than 100%, from 1% to 95%, or from 60% to 90% of the surface of the porous carbon material. When the sulfur-based material is present in the aforementioned range, electrolyte wettability and electrical conductivity may be improved.

The method for producing the sulfur-carbon composite is not limited to a particular one and may include any commonly used method. For example, the sulfur-carbon composite may be produced by mixing sulfur (S₈) with the porous carbon material and performing thermal treatment.

The sulfur-carbon composite may be included in an amount of from 50 wt% to 95 wt%, from 60 wt% to 95 wt%, or from 70 wt% to 90 wt% based on the total 100 wt% of the positive electrode active material layer. When the sulfur-carbon composite is included in the aforementioned range, the positive electrode may cause sufficient electrochemical reaction.

The binder polymer may be used to maintain the positive electrode active material on the positive electrode current collector and organically connect the positive electrode active material particles to increase the bonding strength between them, and may include any commonly used binder polymer. For example, the binder polymer may include any one selected from the group consisting of fluororesin-based binder including polyvinylidene fluoride (PVdF) or polytetrafluoroethylene (PTFE); rubber-based binder including styrene butadiene rubber (SBR), acrylonitrile-butadiene rubber, and styrene-isoprene rubber; cellulose-based binder including carboxyl methyl cellulose (CMC), starch, hydroxy propyl cellulose, regenerated cellulose; polyalcohol-based binder; polyolefin-based binder including polyethylene, polypropylene; poly imide-based binder; polyester-based binder; polyacrylic binder; and silane-based binder or a mixture or copolymer thereof. The binder polymer may be included in an amount of 0.5 wt% to 30 wt% based on the total 100 wt% of the positive electrode active material layer. When the amount of the binder polymer lies in the aforementioned range, the physical properties of the positive electrode may be improved, thereby preventing the active material and the conductive material in the positive electrode being detached, and the ratio of the active material and the conductive material in the positive electrode may be properly controlled, thereby improving the battery capacity.

The conductive material is used to electrically connect the electrolyte to the positive electrode active material to act as a movement path of electrons from the positive electrode current collector to the positive electrode active material, thereby improving electrical conductivity and ionic conductivity. The conductive material may include any material having conductive properties without limitation, for example, carbon black such as Super-P, Denka black, acetylene black, Ketjen black, channel black, furnace black, lamp black, thermal black, carbon black; carbon derivatives such as carbon nanotubes, graphene, and fullerene; conductive fibers such as carbon fibers or metal fibers; fluorocarbon; metal powders such as aluminum powder, nickel powder; or conductive polymer such as polyaniline, polythiophene, polyacetylene, and polypyrrole, used singly or in combination. The conductive material may be included in an amount of from 0.01 wt% to 30 wt% based on the total 100 wt% of the positive electrode active material layer. When the amount of the conductive material lies in the aforementioned range, it may be possible to enhance the movement of electrons from the positive electrode current collector to the positive electrode active material, and properly maintain the ionic conductivity or electrical conductivity of the positive electrode.

In an embodiment of the present disclosure, the positive electrode current collector is not limited to a particular one and may include those having high conductivity without causing a chemical change in the corresponding battery, for example, copper, stainless steel, aluminum, nickel, titanium, palladium, sintered carbon, copper or stainless steel treated with carbon, nickel or silver on the surface, or aluminum-cadmium alloys.

In an embodiment of the present disclosure, the positive electrode may include at least one positive electrode tab. The positive electrode tab may include the same material as the positive electrode current collector, and may consist of the same material as the positive electrode current collector.

The positive electrode tab may be formed in the positive electrode current collector. The above positive electrode tab may be formed to extend in the outward direction from the positive electrode current collector.

In an embodiment of the present disclosure, the positive electrode tab may be formed by extending the positive electrode current collector itself. Alternatively, the positive electrode tab may be formed by electrically connecting a metal (or alloy) to the positive electrode current collector.

For example, the positive electrode tab may be formed by welding the metal (or alloy) to the positive electrode current collector. The metal (or alloy) is not limited to a particular type and may include those having high conductivity without causing a chemical change in the corresponding battery, for example, copper, stainless steel, aluminum, nickel, titanium, palladium, sintered carbon, copper or stainless steel treated with carbon, nickel or silver on the surface, or aluminum-cadmium alloys.

In an embodiment of the present disclosure, the loading amount of the negative electrode may be 1 to 2.5 times as large as the loading amount of the positive electrode.

The loading amount of the negative electrode active material may be 1 to 2.5 times as large as the loading amount of the positive electrode active material. When the loading amount of the positive electrode active material and the negative electrode active material lies in the aforementioned range, the secondary battery may have sufficient energy density and life. In addition, when the negative electrode active material is included in the aforementioned range, the extent of change in resistance of the negative electrode may be small, leading to high accuracy of resistance measurement.

The negative electrode according to the present disclosure is a freestanding type electrode including a negative electrode active material but not having a current collector. In an embodiment of the present disclosure, the negative electrode may include only the negative electrode active material.

The existing secondary batteries use the negative electrode including the negative electrode active material coated on the negative electrode current collector. In addition, the negative electrode current collector includes materials having high conductivity without causing a chemical change in the battery, for example, copper and stainless steel. However, when voltage is applied to measure the resistance of the negative electrode, the electric current flows to the negative electrode current collector having high conductivity. The measured resistance is the resistance of the negative electrode current collector having high conductivity. The degree of degradation of the negative electrode is greatly affected by the negative electrode active material into which lithium is intercalated/deintercalated. In the case of the negative electrode including the negative electrode current collector like the existing secondary battery, when the resistance of the negative electrode is measured, the resistance of the negative electrode active material is not measured, and the resistance of the negative electrode current collector is measured, so it is impossible to determine the degree of degradation of the negative electrode active material by the measured resistance. Accordingly, the negative electrode included in the secondary battery according to the present disclosure is a freestanding type electrode having no current collector, and the degree of degradation of the negative electrode active material may be determined by measuring the resistance of the negative electrode.

The negative electrode active material of the negative electrode according to the present disclosure includes at least one lithium-based material of lithium metal and lithium alloy. The negative electrode may consist of at least one lithium-based material of lithium metal and lithium alloy.

The lithium alloy may include elements that form alloys with lithium, for example, Si, Sn, C, Pt, Ir, Ni, Cu, Ti, Na, K, Rb, Cs, Fr, Be, Mg, Ca, Sr, Sb, Pb, In, Zn, Ba, Ra, Ge, Al or alloys thereof.

The negative electrode according to the present disclosure includes the first negative electrode tab and the second negative electrode tab.

Because the negative electrode of the present disclosure includes two or more negative electrode tabs, the resistance of the negative electrode may be measured by connecting a resistance measurement device to different negative electrode tabs. The resistance measurement is performed by applying the electric current to one negative electrode tab and receiving the electric current from the other negative electrode tab.

However, when the distance between the negative electrode tabs is short, the electric current applied to one negative electrode tab may directly escape from the other negative electrode tab, or the electric current applied to one negative electrode tab may escape from the other negative electrode tab through only a part of the negative electrode. Therefore, when the distance between the negative electrode tabs is short, the resistance of the negative electrode may not be accurately measured.

The first negative electrode tab and the second negative electrode tab included in the negative electrode according to the present disclosure are extended in opposite directions. Therefore, while the electric current applied to one negative electrode tab escapes from the negative electrode, the electric current may flow over as a wide area of the negative electrode as possible, thereby accurately measuring the resistance of the negative electrode and accurately determining the degree of degradation of the negative electrode.

The first negative electrode tab and the second negative electrode tab extended in opposite directions represent that the second negative electrode tab is disposed on the opposite side of the negative electrode to the side where the first negative electrode tab is disposed, wherein the opposite sides do not contact each other. For example, when the negative electrode is a hexahedral structure, the first negative electrode tab may be disposed on one of the sides of the hexahedron, and the second negative electrode tab may be disposed on the side opposite the side where the first negative electrode tab is disposed, wherein the opposite sides do not contact each other.

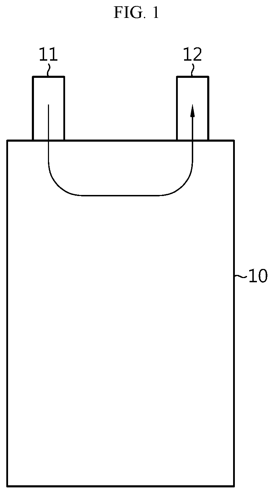

FIG. 1 is a diagram showing the negative electrode according to the related art. In FIG. 1, the arrow indicates the flow of current.

Referring to FIG. 1, the first negative electrode tab 11 and the second negative electrode tab 12 are extended in the same direction. In this case, the electric current applied to the first negative electrode tab 11 escapes from the second negative electrode tab 12 via only a part of the negative electrode 10. Therefore, it is impossible to accurately measure the resistance across the entire negative electrode 10, and deviation in measurement may be large each time the resistance is measured.

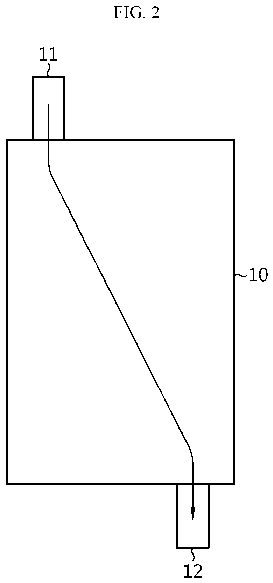

FIG. 2 is a diagram showing the negative electrode according to an embodiment of the present disclosure. In FIG. 2, the arrow indicate the flow of current.

Referring to FIG. 2, the first negative electrode tab 11 and the second negative electrode tab 12 are extended in opposite directions with respect to the negative electrode 10. Therefore, the electric current applied to the first negative electrode tab 11 to measure the resistance of the negative electrode 10 may pass through the negative electrode 10 until it escapes from the second negative electrode tab 12. Therefore, in this case, the resistance across the entire negative electrode 10 may be accurately measured, and deviation in measurement may be small each time the resistance is measured.

In an embodiment of the present disclosure, the first negative electrode tab and the second negative electrode tab may be extended outward from an end in each direction at both ends in the width direction of the negative electrode or both ends in the length direction of the negative electrode. The width direction may mean a short side of the negative electrode, and the length direction may mean a long side of the negative electrode.

For example, the cross section (to be specific, the horizontal cross section) of the negative electrode may have a rectangular shape with an aspect ratio of 1 or more. Here, the shorter side among the two adjacent sides may be referred to as a width-direction side, and the longer side may be referred to as a length-direction side. In addition, the first negative electrode tab and the second negative electrode tab may be extended outward from different width-direction sides, or may be extended outward from different length-direction sides.

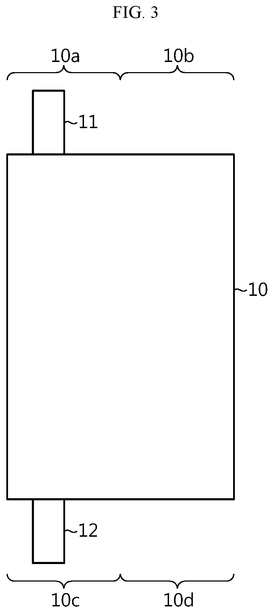

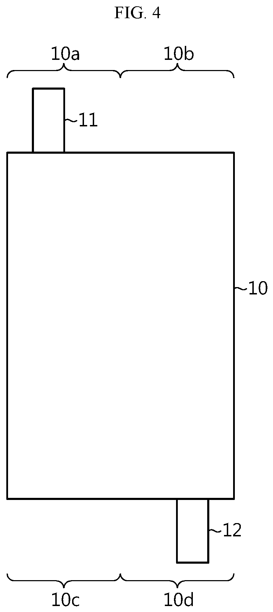

FIGS. 3 and 4 are diagrams showing the first negative electrode tab 11 and the second negative electrode tab 12 formed on different width-direction sides of the negative electrode 10.

Each of the width-direction sides of the negative electrode 10 may be divided into two equal parts, and one width-direction side may be divided into a 10a region and a 10b region, and the other width-direction side may be divided into a 10c region and a 10d region. With respect to the negative electrode 10, the 10a region and the 10c region are line-symmetrical to each other, and the 10b region and the 10d region are line-symmetrical to each other. In addition, the 10a region and the 10d region are point-symmetrical to each other, and the 10b region and the 10c region are point-symmetrical to each other.

The line symmetry may represent that the two regions of the width-direction sides of the negative electrode may overlap in symmetry with respect to a straight line, and point symmetry may represent that the two regions of the width-direction sides of the negative electrode do not overlap in symmetry with respect to a straight line, but they are located at the same distance from one point between them.

Referring to FIG. 3, the first negative electrode tab 11 is located in the 10a region, and the second negative electrode tab 12 is located in the 10c region. In this case, the first negative electrode tab 11 and the second negative electrode tab 12 are located in line symmetry with respect to the negative electrode.

Referring to FIG. 4, the first negative electrode tab 11 is located in the 10a region, and the second negative electrode tab 12 is located in the 10d region. In this case, the first negative electrode tab 11 and the second negative electrode tab 12 are located in point symmetry with respect to the negative electrode.

FIGS. 3 and 4 show the width-direction sides, each divided into two equal parts, totaling the 10a region, the 10b region, the 10c region, and the 10d region, to describe that the first negative electrode tab and the second negative electrode tab are located in the point-symmetrical or line-symmetrical regions. In the present disclosure, the location of the first negative electrode tab and the second negative electrode tab is not limited to the 10a region to the 10d region, and may be located at any position on the width-direction side or the length-direction side. For example, the first negative electrode tab may be located in a region including the central portion of the width-direction side, and the second negative electrode tab may be positioned in a region including the central portion of the other width-direction side.

As described above, the first negative electrode tab and the second negative electrode tab in the negative electrode according to the present disclosure may be each formed in the line-symmetrical regions, and may be formed in the point-symmetrical regions. When the first negative electrode tab and the second negative electrode tab are formed in the line-symmetrical or point-symmetrical regions, the electric current may pass through the positive electrode over a wide area while resistance is measured, thereby accurately measuring the resistance of the negative electrode.

In an embodiment of the present disclosure, the first negative electrode tab and/or the second negative electrode tab may be formed by extending the lithium-based material from the negative electrode of the lithium-based material. That is, the first negative electrode tab and the second negative electrode tab may be made of the same material as the negative electrode.

In an embodiment of the present disclosure, the first negative electrode tab and/or the second negative electrode tab may be formed by electrically connecting a metal (or alloy) to the negative electrode of the lithium-based material.

For example, the first negative electrode tab and/or the second negative electrode tab may be formed by welding the metal to the negative electrode. The metal is not limited to a particular type and may include any metal having high conductivity while not causing a chemical change in the corresponding battery. For example, the metal may include copper, stainless steel, aluminum, nickel, titanium, palladium, sintered carbon, copper or stainless steel treated with carbon, nickel or silver on the surface, or aluminum-cadmium alloys.

In an embodiment of the present disclosure, the first negative electrode tab and the second negative electrode tab may be configured to be connected to the resistance measurement device for measuring the resistance of the negative electrode between them. The resistance of the negative electrode measured by the resistance measurement device may be used to determine the degree of degradation of the negative electrode and the degree of degradation of the secondary battery including the negative electrode.

For example, when the secondary battery according to the present disclosure is housed in a pouch case, the first negative electrode tab and the second negative electrode tab may be protruded outward from the pouch case. Alternatively, an electrode lead may be attached to the first negative electrode tab and/or the second negative electrode tab, and the attached electrode lead may be protruded outward from the pouch case. The resistance measurement device may be electrically connected to the protruded negative electrode tab or the protruded electrode lead to measure the resistance of the negative electrode.

A second aspect of the present disclosure relates to a method for measuring the resistance of the negative electrode of the secondary battery according to an aspect of the present disclosure.

The method for measuring the resistance of the negative electrode according to an aspect of the present disclosure may include the step of:
connecting the resistance measurement device to the first negative electrode tab and the second negative electrode tab included in the negative electrode of the secondary battery according to an aspect of the present disclosure, to measure the resistance of the negative electrode. The resistance measurement device may be directly or indirectly connected to the first negative electrode tab and the second negative electrode tab. For example, the negative lead may be attached to the first negative electrode tab and/or the second negative electrode tab, and the resistance measurement device may be connected to the negative lead.

In one implementation of the present disclosure, the resistance measurement may be done using Electrochemical Impedance Spectroscopy (EIS). The EIS is a resistance measurement method by applying an alternating current (AC) voltage to a target and plotting the result of applying the AC voltage to the sample at a frequency to interpret the Nyquist plot. The EIS provides more diverse analysis than constant current or constant voltage measurement methods.

In an embodiment of the present disclosure, the amplitude of the voltage when measuring the resistance may range from 0.01 mV to 0.5 mV, or from 0.01 mV to 0.2 mV, or from 0.2 mV to 0.5 mV. When the amplitude of the voltage lies in the aforementioned range, it may be possible to increase the accuracy of resistance measurement and prevent damage to the secondary battery.

In an embodiment of the present disclosure, the frequency of the voltage when measuring the resistance may range from 100 Hz to 1000 Hz.

In an embodiment of the present disclosure, a charger/discharger may be connected to a positive electrode tab and a first negative electrode tab to charge or discharge the secondary battery. At the same time as the charge/discharge of the secondary battery, the resistance measurement device may be connected to the first negative electrode tab and the second negative electrode tab to measure the resistance of the negative electrode. That is, the resistance of the negative electrode may be measured at the same time as charging or discharging of the secondary battery, and the degree of degradation of the negative electrode and the secondary battery may be determined from the measured resistance of the negative electrode.

In one embodiment of the present disclosure, the resistance measurement may be performed each time the State of Charge (SOC) of the secondary battery changes by 5% ~ 20%, 5% ~ 10%, or 10% ~ 20%.

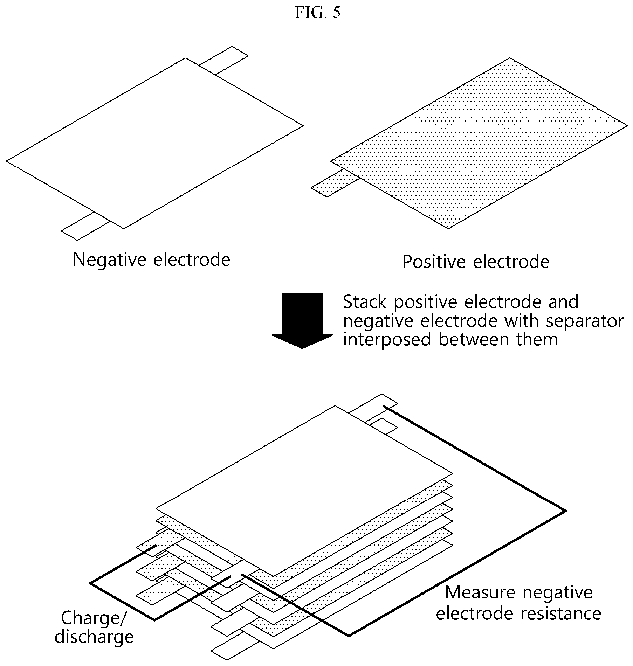

FIG. 5 is a diagram showing the negative electrode having two negative electrode tabs in opposite directions and the positive electrode having one positive electrode tab stacked with the separator interposed between them. When the charger/discharger is connected to one positive electrode tab and one negative electrode tab arranged in the same direction, the secondary battery may operate. In addition, the resistance of the negative electrode may be measured by connecting the resistance measurement device to the two negative electrode tabs formed in opposite directions.

Hereinafter, the present disclosure will be described in more detail through examples, but the following examples are intended to illustrate the present disclosure, and the scope of the present disclosure is not limited thereto.

### Example 1

A 50 *µ*m thick lithium metal foil having a loading amount of 5.16 mAh/cm² was prepared, and the lithium metal foil was punched to form a first negative electrode tab and a second negative electrode tab. In this instance, the first negative electrode tab and the second negative electrode tab were formed on each of the width-direction sides of the lithium metal foil, and they were formed in point-symmetrical regions with respect to the lithium metal.

As a positive electrode active material, a sulfur-carbon composite including sulfur (S₈) loaded on carbon nanotubes was prepared. In this instance, a weight ratio of carbon nanotubes and sulfur was set to 3:7. The prepared sulfur-carbon composite and polyacrylic acid (PAA) as a binder polymer were mixed at a weight ratio of 96:4 and added to water to form a positive electrode slurry composition. The positive electrode slurry composition was applied to an aluminum current collector and dried to manufacture a positive electrode. The loading of the manufactured positive electrode was 3.3 mAh/cm². The aluminum current collector had a positive electrode tab formed on one width-direction side.

The positive electrode and the negative electrode were placed with a polyethylene separator having a thickness of 16 *µ*m and a porosity of 46 vol% interposed between them to manufacture an electrode assembly, the electrode assembly was placed in an aluminum pouch, and injecting an electrolyte solution containing 1M lithium bis(trifluoromethanesulfonyl)imide (LiTFSI) and 1 wt% lithium nitrate (LiNO₃) dissolved in a mixed solvent of 1,3-dioxolane (DOL) and dimethyl ether (DME) at a volume ratio of 1:1.

### Experimental example

The charger/discharger was connected to the positive electrode tab and the first negative electrode tab of the manufactured secondary battery to operate the secondary battery in the range between 1.8V and 2.5 V in an environment of 25°C in order to measure the capacity. In this instance, charging was performed in 0.2C CC mode and discharging was performed in 0.3C CC mode.

The resistance measurement device was connected to the first negative electrode tab and the second negative electrode tab, to measure the resistance each time the SOC (via the charger/discharger) changes by 10%. The resistance measurement was done using EIS in a frequency range between 100 Hz and 1000 Hz, and the amplitude of voltage was 0.2 mV.

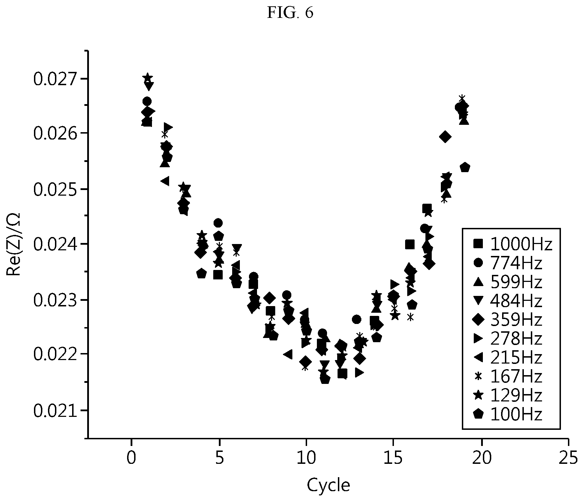

FIG. 6 is a graph showing a change in resistance during a charge/discharge cycle of the secondary battery of Example 1. When charging from SOC 0% to SOC 100% and then discharging to SOC 0%, the resistance was measured at 10% SOC intervals. The charging was performed in 0.2C CC mode at 25°C, and the discharging was performed in 0.3C CC mode at 25°C.

It was confirmed that the resistance is lower as it is closer to SOC 100%, and the resistance is higher as it is closer to SOC 0%. This reveals the increase in resistance with decreasing thickness of the lithium metal foil during discharging, and the decrease in resistance with increasing thickness of the lithium metal foil during charging.

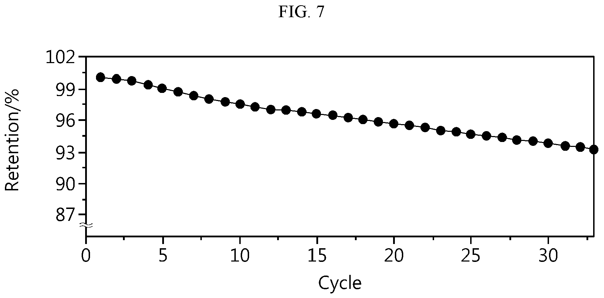

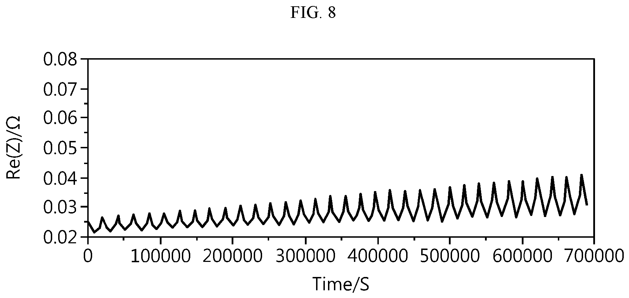

FIG. 7 shows the discharge capacity retention measured during the charge and discharge cycles of the secondary battery of Example 1, and FIG. 8 shows a change in resistance measured during the charge and discharge cycles of the secondary battery of Example 1. The charging was performed in 0.2C CC mode at 25°C, and the discharging was performed in 0.3C CC at 25°C.

In this instance, the discharge capacity retention was calculated by the following equation. Discharge capacity retention (%) = [(discharge capacity in first cycle - discharge capacity in nth cycle) / discharge capacity in first cycle] × 100

Referring to FIGS. 7 and 8, it was confirmed that as the number of cycles increases, the peak resistance (resistance at SOC 0% in each cycle) increases. This is because the resistance increases as the lithium metal foil of the negative electrode degrades. That is, information associated with the degradation of the secondary battery may be obtained by measuring the resistance of the lithium metal negative electrode by the method for measuring the resistance of the negative electrode according to the present disclosure.

Although the present disclosure has been hereinabove described with regard to a limited number of embodiments and drawings, the present disclosure is not limited thereto and it is obvious to those skilled in the art that various modifications and changes may be made thereto within the technical aspect of the present disclosure and the scope of the appended claims and their equivalents.

## Claims

1. A secondary battery comprising:
a positive electrode; a negative electrode; and a separator between the positive electrode and the negative electrode,
wherein the negative electrode is a free-standing type electrode including a negative electrode active material but not having a current collector,
wherein the negative electrode active material includes at least one lithium-based material of a lithium metal and a lithium alloy, and
wherein the negative electrode includes a first negative electrode tab and a second negative electrode tab extended in opposite directions.

2. The secondary battery according to claim 1,
wherein the positive electrode has a positive electrode active material layer on at least one surface of a positive electrode current collector, and the positive electrode active material layer includes a sulfur-carbon composite and a binder polymer.

3. The secondary battery according to claim 1,
wherein the positive electrode includes a positive electrode tab.

4. The secondary battery according to claim 1,
wherein the negative electrode consists of the at least one lithium-based material of the lithium metal and the lithium alloy.

5. The secondary battery according to claim 1,
wherein the first negative electrode tab and the second negative electrode tab are each extended outward from each of two ends of the negative electrode on two sides in a width direction or a length direction.

6. The secondary battery according to claim 1,
wherein the first negative electrode tab and the second negative electrode tab are located in line-symmetrical regions with respect to the negative electrode.

7. The secondary battery according to claim 1,
wherein the first negative electrode tab and the second negative electrode tab are located in point-symmetrical regions with respect to the negative electrode.

8. The secondary battery according to claim 1,
wherein the first negative electrode tab and the second negative electrode tab are configured to be connected to a resistance measurement device for measuring the resistance of the negative electrode.

9. The secondary battery according to claim 1,
wherein the secondary battery is configured such that a degree of electrical degradation of the negative electrode and the secondary battery is observed by connecting a resistance measurement device to the first negative electrode tab and the second negative electrode tab.

10. The secondary battery according to claim 1,
wherein the positive electrode has a positive electrode active material layer on at least one surface of a positive electrode current collector, and a loading amount of the negative electrode is 1 to 2.5 times as large as a loading amount of a positive electrode active material.

11. A method for measuring the resistance of the negative electrode of the secondary battery according to any one of claims 1 to 10, the method comprising the step of:
connecting the resistance measurement device to the first negative electrode tab and the second negative electrode tab to measure the resistance of the negative electrode.

12. The method for measuring the resistance of the negative electrode according to claim 11,
wherein the resistance measurement is performed using electrochemical impedance spectroscopy.

13. The method for measuring the resistance of the negative electrode according to claim 11,
wherein the resistance measurement is performed in an amplitude of voltage between 0.01 mV and 0.5 mV.

14. The method for measuring the resistance of the negative electrode according to claim 11,
wherein the resistance measurement is performed at a frequency between 100 Hz and 1000 Hz.

15. The method for measuring the resistance of the negative electrode according to claim 11,
wherein the resistance measurement is performed every time a state of charge (SOC) of the secondary battery changes by 5% ~ 20%.
